# EUROPÄISCHE PATENTANMELDUNG

(11) **EP 2 660 191 A2**
(43) Veröffentlichungstag der Anmeldung: **06.11.2013**
(21) Anmeldenummer: 13165351.1
(22) Anmeldetag: 25.04.2013
(51) Int. Cl.: B81B 7/00

(54) **Gehäuse zur Verkapselung eines Mikroscannerspiegels**

(30) Priorität: 03.05.2012 DE 102012207376
(71) Anmelder: Fraunhofer-Gesellschaft zur Förderung der angewandten Forschung e.V., 80686 München (DE)
(72) Erfinder: Langa, Sergiu, 01328 Dresden (DE)
(74) Vertreter: Stöckeler, Ferdinand

(57) **Zusammenfassung**

Ein Gehäuse zur Verkapselung eines Mikroscannerspiegels weist einen Einfallfensterbereich, einen Ausfallfensterbereich und eine Blende auf, wobei der Einfallfensterbereich und der Ausfallfensterbereich zumindest teilweise in einem vorbestimmten Bereich voneinander getrennt sind, in dem die Blende angeordnet ist.

## Beschreibung

Ausführungsbeispiele der vorliegenden Erfindung beziehen sich auf ein Gehäuse zur Verkapselung eines Mikroscannerspiegels. Weitere Ausführungsbeispiele der vorliegenden Erfindung beziehen sich auf eine Struktur für die Vermeidung von parasitären Reflexionen bei der Verkapselung von Mikroscannerspiegeln. Weitere Ausführungsbeispiele der vorliegenden Erfindung beziehen sich auf die Vermeidung von parasitären Reflexionen durch eine Blende.

Mikroscannerspiegel werden, unter anderen möglichen Anwendungen, auch als Hauptkomponente für ultra-kompakte Laser Projektionssysteme verwendet [M.Scholles, A. Bräuer, K. Frommhagen, Ch. Gerwig, H. Lakner, H. Schenk, M. Schwarzenberg, Proc. SPIE: MOEMS and Miniaturized Systems VI, 6466 (2007)]. Es gibt Bestrebungen, solche Projektionssysteme in Zukunft auch in Smartphones, Tablets etc. zu integrieren. Eine der wichtigsten Eigenschaften, die so ein System mitbringen soll, um für mobile Anwendungen berücksichtig zu werden, ist Energieeffizienz.

Mikroscannerspiegel sind mechanisch-oszillierende Elemente und benötigen daher in der Regel viel Energie, um gegen den Widerstand der Luft zu oszillieren. Um die Verbrauchsenergie zu senken wäre es angebracht, die Mikroscanner nicht in der Luft, sondern im Vakuum oszillieren zu lassen, d.h. die Mikroscannerspiegel in ein vakuumdichtes Gehäuse zu verkapseln.

Eine sehr effiziente Möglichkeit, was die Verkapselung betrifft, wäre die Mikroscannerspiegel auf Waferebene in Vakuum zu verkapseln und anschließend die Wafer in einzelne, schon verkapselte Chips mit einer Wafersäge zu trennen. Verkapselung auf Waferebene ist durch verschiedene Waferbondmethoden möglich [V. Dragoi, http://www.ieee.org/organizations/pubs/newsletters/leos/dec09/RH-Wafer_Bonding.html (2009)] [G. A. Riley, Advanced Packaging Magazine 13(5), 21 (2004)] [K. Najafi, Micromachining and Microfabrication Process Technology VIII, Proceedings of SPIE 4979, 0 (2003)].

Eine Besonderheit bei der Vakuumverkapselung von Mikroscannerspiegeln auf Waferebene ist die Notwendigkeit eines Fensters, welches in das Gehäuse des Chips bei der Verkapselung eingebaut werden muss. Durch das eingebaute Fenster kann das Laserlicht in das Gehäuse hinein und aus dem Gehäuse hinaus gelangen, so dass die Funktion des Chips gewährleistet wird [Hofmann et. al., MOEMS and Miniaturized Systems VII, ed. D.L. Dickensheets, H. Schenk, Proc. of SPIE 6887 , 688706 (2008)].

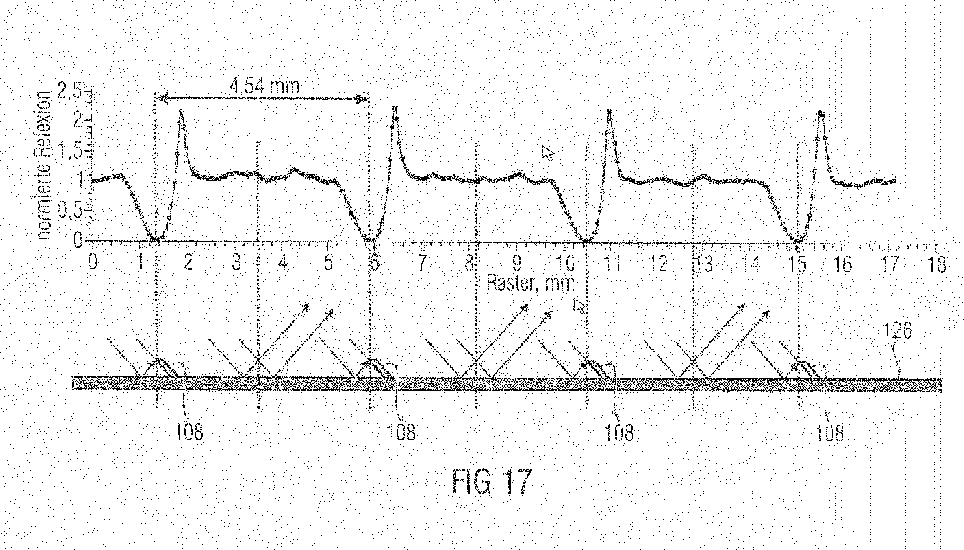

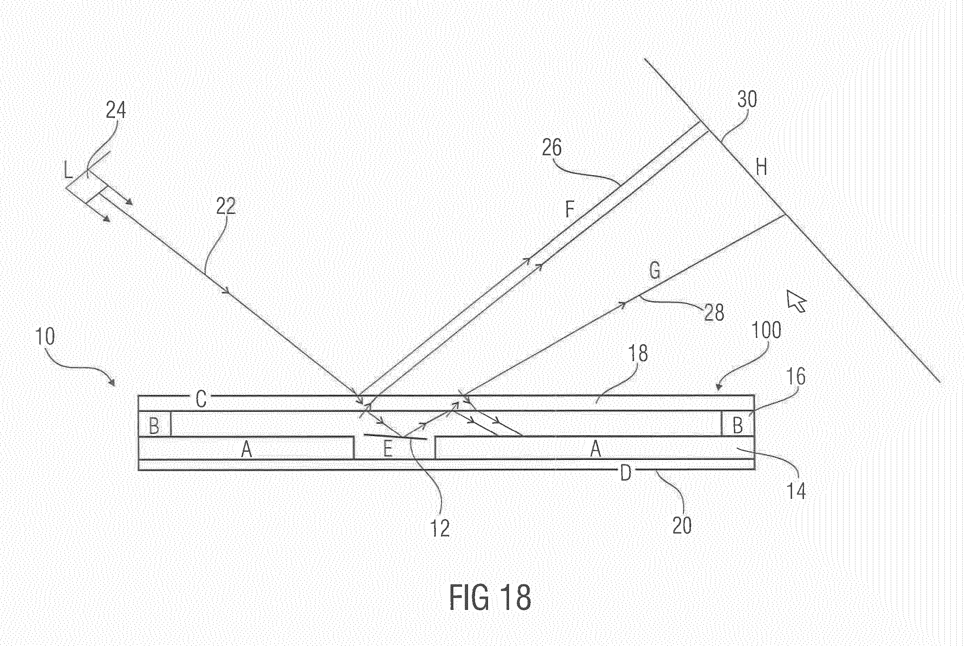

Fig. 18 zeigt eine schematische Ansicht eines herkömmlichen Gehäuses 10 zur Verkapselung eines Mikroscannerspiegels 12. Auf einem Mikrospiegelchip 14 (A), z.B. aus Silizium, wird ein Abstandshalter (engl.: spacer) 16 (B) gebondet. Auf dem Abstandshalter 16 wird dann ein Glasfenster 18 (C) aufgebracht bzw. gebondet. Außerdem wird auf einer Rückseite des Chips 14 noch ein Unterdeckel 20 (D), z.B. ein Silizium Unterdeckel, gebondet, so dass der Mikroscannerspiegel 12 (E) keinen direkten Kontakt mit der Umwelt mehr hat, bzw. unter umstanden in Vakuum verkapselt ist. Mit anderen Worten, Fig. 17 zeigt eine einfache Verkapselung eines Mikroscannerspiegels in Vakuum. Die parasitären Reflexionen 26 sind nicht erwünscht weil diese die Qualität des projizierten Bildes beeinflussen.

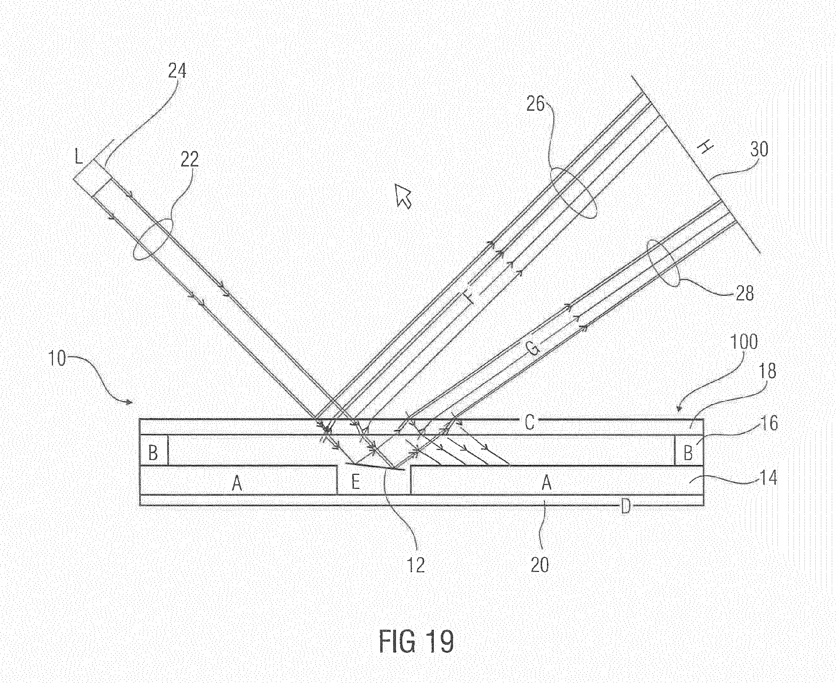

Fig. 19 zeigt eine schematische Ansicht eines herkömmlichen Gehäuses 10 zur Verkapselung eines Mikroscannerspiegels 12. Im Vergleich zu Fig. 18 sind eine Mehrzahl von Lichtstrahlen dargestellt.

Das Glasfenster 18, so wie es in den Fig. 18 und 19 dargestellt ist, hat einen wesentlichen Nachteil. Ein Teil des Lichts 22 des Lasers 24 wird an der oberen und unteren Oberfläche des Glases 18 reflektiert. Diese Reflektionen 26 (F) werden als "parasitär" empfunden, weil diese in der gleichen Region wie das vom Mikroscannerspiegel 12 reflektierte nützliche Licht 28 (G) reflektiert werden und so die Qualität des von dem Mikroscannerspiegel 12 generierten Bildes auf der Leinwand bzw. dem Detektor 30 (H) beeinflussen.

Aus diesem Grund müssen die parasitären Reflektionen vermieden, reduziert, oder wenn das nicht möglich ist, außerhalb der Region in der das nützliche Bild projiziert wird, projiziert werden.

In der Literatur gibt es mehrere Ansätze wie die parasitären Reflexionen "bekämpft" werden können [Hofmann et. al., MOEMS and Miniaturized Systems VII, ed. D.L. Dickensheets, H. Schenk, Proc. of SPIE 6887 , 688706 (2008)]. Die meisten Ansätze basieren auf der Idee, das Glasfenster 18 und den Mikroscannerspiegel 12 relativ zueinander zu kippen.

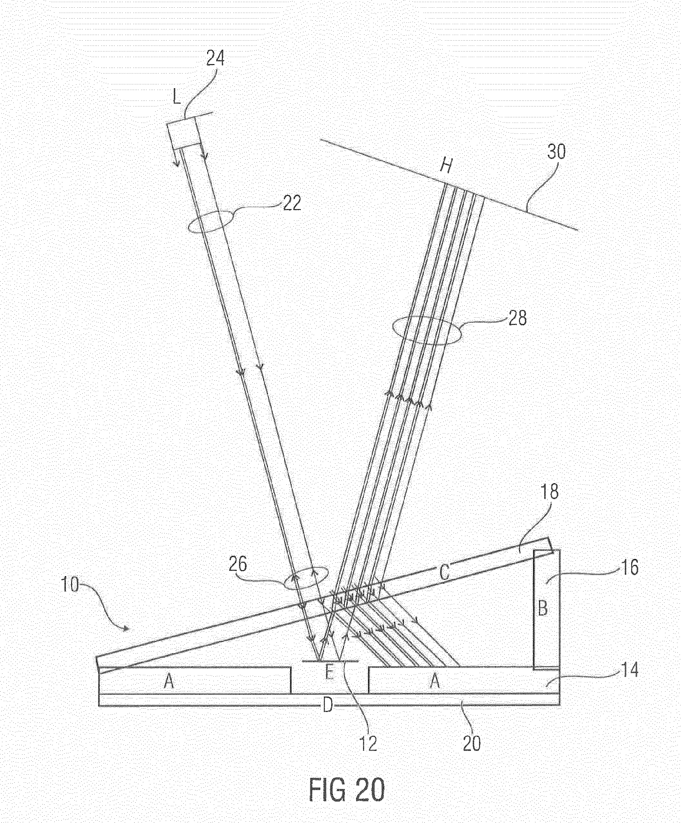

Fig. 20 zeigt eine schematische Ansicht eines herkömmlichen Gehäuses 10 zur Verkapselung eines Mikroscannerspiegels 12 bei dem das Glasfenster 18 relativ zu einer Spiegelebene des Mikroscannerspiegels 12 gekippt ist. In diesem Fall fällt das Licht 22 senkrecht auf das Glasfenster 18 und aus diesem Grund werden die parasitären Reflexionen 26 zurück zu der Quelle bzw. dem Laser 24 reflektiert und nicht auf die Leinwand bzw. den Detektor 30 projiziert. Mit anderen Worten, in Fig. 18 ist das Glasfenster 18 relativ zu der Spiegelebene gekippt, so dass die parasitären Reflexionen 26 nicht in das Bild projiziert werden.

Zur Realisierung der oben vorgestellten Lösung wird auf Waferebene eine Glasstrukturierungsmethode benötigt, um das gekippte Fenster 18 herzustellen. Glasstrukturierung ist keine leichte Aufgabe, insbesondere für gekippte Glasstrukturen. Das Ganze wird bei der Verkapselung von Mikroscannerspiegeln noch mal komplizierter, weil das Glasfenster 18 nach der Strukturierung eine gewisse optische Qualität aufweisen muss. D.h. die Rauigkeit und Ebenheit des Glases 18 müssen nach der Strukturierung sehr strenge optische Anforderungen erfüllen, z.B. Rauigkeit des Glases darf höchstens λ/4 betragen. In der W02009/112138A2 wird eine solche Glasstrukturierungsmethode beschrieben.

Alternativ kann der Mikroscannerspiegel 12 permanent relativ zu dem Glasfenster 18 gekippt werden. Das macht allerdings den Chip 20 größer, weil zusätzlich zu den zwei beweglichen Rahmen, die für die 2D Projektion notwendig sind, ein dritter beweglicher Rahmen notwendig ist, der die anderen zwei Rahmen beinhaltet. Dieser dritte bewegliche Rahmen wird dann permanent relativ zu dem Glasfenster 18 gekippt, so dass der Mikroscannerspiegel 12 auch permanent zu dem Fenster 18 gekippt ist [Hofmann et. al., MOEMS and Miniaturized Systems VII, ed. D.L. Dickensheets, H. Schenk, Proc. of SPIE 6887 , 688706 (2008)].

Verfahren zur Herstellung von gekippten bzw. geformten Fenstern 18 für die Verkapselung von Mikroscannerspiegeln 12 auf Wafer- oder Chipebene werden in den W02009/112138A2, US2008/0280124A1, WO2007/069165, US2006/0176539A1, US2007/0024549A1, US2007/0008601A1 und KR20110032984A beschrieben. Die meisten Lösungen benötigen aber eine dreidimensionale Strukturierung des Glases 18.

Eine andere Möglichkeit, die parasitären Reflexionen 26 zu vermeiden, ist die Lichtquelle 24 in das Gehäuse zu integrieren, wie dies aus der US007180640B2 hervorgeht. Eine Realisierung auf Waferebene ist jedoch relativ kompliziert.

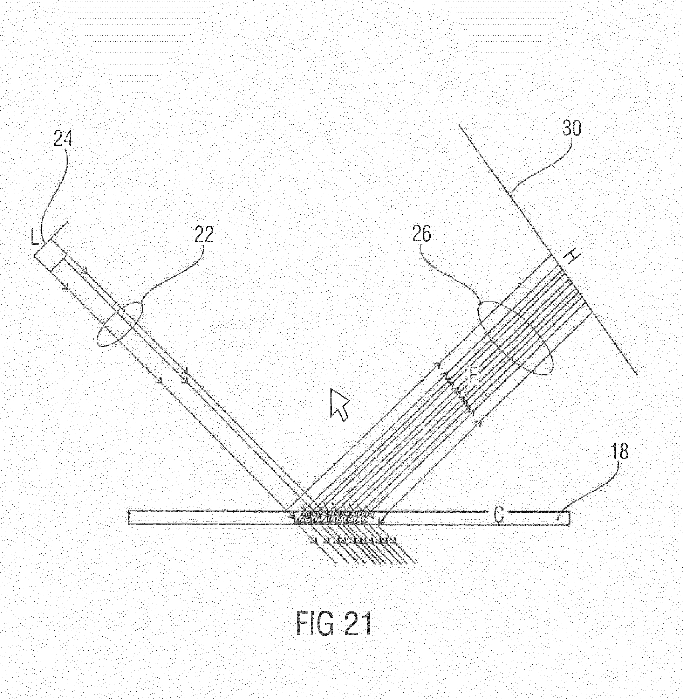

Fig. 21 zeigt eine schematische Ansicht einer herkömmlichen Glasscheibe 18 sowie der parasitären Reflexionen, die an der Oberseite und Unterseite der Glasscheibe 18 durch einen einfallenden Lichtstrahl hervorgerufen werden. Eine Glasscheibe aus z.B. Pyrex reflektiert dabei ca. 8 % des einfallenden Lichts bzw. Lichtstrahls 22.

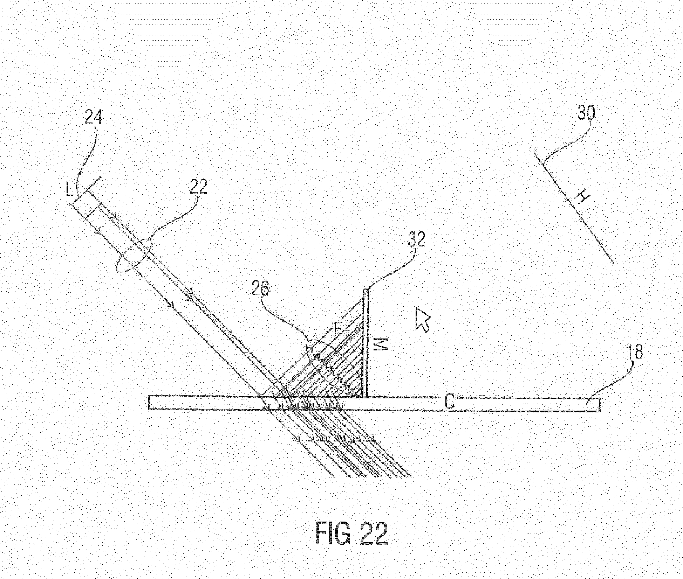

Die einfachste Methode die Reflexionen, die in das projizierte Bild reflektiert werden zu unterdrücken, ist eine Blende 32 zu benutzen. Eine Möglichkeit wäre die Blende so zu platzieren wie in der nachfolgenden Fig. 22 dargestellt ist.

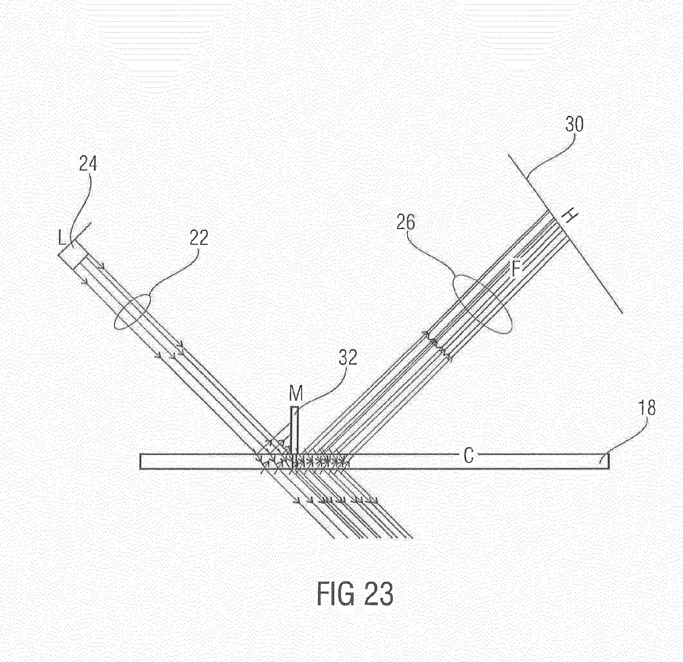

Fig. 22 zeigt eine schematische Ansicht einer herkömmlichen Glasscheibe 18 und einer herkömmlichen Blende 32 zur Unterdrückung parasitärer Reflexionen 26. Der Nachteil ist in diesem Fall die recht hohe Blende 32, die notwendig ist, um alle Reflexionen 26 komplett zu blockieren. Beispielsweise wird bei einem Laserstrahl 22 mit einem Durchmesser von 500 µm, einem Einfallswinkel von 45° und einer Glasdicke von 300 µm, eine Blende 32 benötigt, die eine Höhe von mehr als 2 mm aufweist. So eine hohe Blende 32 ist aus mehreren Gründen nicht erwünscht. Zum einen führt eine sehr hohe Blende 32 automatisch zu einem dickeren Chip was jedoch für mobile Anwendungen nicht erwünscht ist. Zum anderen ist es eine Herausforderung eine 2 mm hohe Blende 32 auf Waferebene herzustellen. Bei 6 Zoll Wafern beträgt die Standard Waferdicke 675µm. 2 mm dicke Scheiben können von den meisten Werkzeugen (engl.: tools) nicht prozessiert werden. D.h., um das Problem zu lösen und eine 2 mm hohe Blende 32 herzustellen, müssten drei 6 Zoll Wafer strukturiert werden und anschließend mittels Bonden oder Kleben miteinander verbunden werden. Um die Höhe der Blende 32 zu reduzieren, könnte die Blende 32 so platziert werden, wie in der nachfolgenden Fig. 23 dargestellt ist.

Fig. 23 zeigt eine schematische Ansicht einer herkömmlichen Glasscheibe 18 und einer herkömmlichen Blende 32 zur Unterdrückung parasitärer Reflexionen 26. Im Vergleich zu Fig. 22 weist die Blende 32 eine geringere Höhe auf. Die parasitären Reflexionen 26 werden durch die kleinere Blende 32 jedoch nicht vollständig unterdrückt. In diesem Fall fungiert die Glasscheibe 18 als Wellenleiter wodurch ein Teil des einfallenden Lichts 22 unter der Blende durch die Glasscheibe übertragen wird, was zu parasitären Reflexionen in Höhe von ca. 1 % führt.

Der vorliegenden Erfindung liegt somit die Aufgabe zugrunde, ein Konzept zum Reduzieren von parasitären Reflexionen bei der Verkapselung von Mikroscannerspiegeln zu schaffen.

Diese Aufgabe wird gelöst durch ein Gehäuse zur Verkapselung eines Mikroscannerspiegels gemäß Patentanspruch 1 und einem Projektionssystem gemäß Patentanspruch 12. Ausführungsbeispiele der vorliegenden Erfindung schaffen ein Gehäuse zur Verkapselung eines Mikroscannerspiegels. Das Gehäuse weist einen Einfallfensterbereich, einen Ausfallfensterbereich und eine Blende auf, wobei der Einfallfensterbereich und der Ausfallfensterbereich in einem vorbestimmten Bereich zumindest teilweise voneinander getrennt sind, in dem die Blende angeordnet ist.

Bei Ausführungsbeispielen der vorliegenden Erfindung werden parasitäre Reflexionen dadurch vermindert bzw. reduziert, dass der Einfallfensterbereich und der Ausfallfensterbereich in dem vorgegebenen Bereich, in dem die Blende angeordnet ist, zumindest teilweise voneinander getrennt sind. Dadurch, dass der Einfallfensterbereich und der Ausfallfensterbereich in dem vorgegebenen Bereich zumindest teilweise voneinander getrennt sind, wird eine Übertragung eines Teils des einfallenden Lichtstrahl von dem Einfallfensterbereich durch den vorgegebenen Bereich in den Ausfallfensterbereich (z.B. unterhalb der Blende) vermindert bzw. reduziert.

Ausführungsbeispiele der vorliegenden Erfindung werden bezugnehmend auf die beiliegenden Zeichnungen näher erläutert. Es zeigen:
- Fig. 1: eine schematische Ansicht eines Gehäuses zur Verkapselung eines Mikroscannerspiegels gemäß einem Ausführungsbeispiel der vorliegenden Erfindung;
- Fig. 2: eine schematische Ansicht eines Gehäuses zur Verkapselung eines Mikroscannerspiegels gemäß einem weiteren Ausführungsbeispiel der vorliegenden Erfindung;
- Fig. 3: eine schematische Ansicht eines Projektionssystems gemäß einem Ausführungsbeispiel der vorliegenden Erfindung;
- Fig. 4: eine schematische Ansicht eines Projektionssystems gemäß einem weiteren Ausführungsbeispiel der vorliegenden Erfindung;
- Fig. 5: eine schematische Ansicht einer Glasscheibe und einer Blende, wobei die Glasscheibe unterhalb der Blende abgeschnitten ist;
- Fig. 6: eine schematische Ansicht eines Projektionssystems mit einem Gehäuse zur Verkapselung eines Mikroscannerspiegels gemäß einem Ausführungsbeispiel der vorliegenden Erfindung;
- Fig. 7: eine schematische Ansicht eines Projektionssystems mit einem Gehäuse zur Verkapselung eines Mikroscannerspiegels bei dem Rausch Reflexionen bedingt durch einen zu geringen Abstand zwischen Fenster und Spiegelebene auftreten;
- Fig. 8: eine schematische Ansicht eines Projektionssystems mit einem Gehäuse zur Verkapselung eines Mikroscannerspiegels gemäß einem Ausführungsbeispiel der vorliegenden Erfindung;
- Fig. 9: eine schematische Ansicht einer Blende und eines Fensters gemäß einem Ausführungsbeispiel der vorliegenden Erfindung;
- Fig. 10: eine schematische Ansicht einer Blende und eines Fensters nach dem Zusammenfügen gemäß einem Ausführungsbeispiel der vorliegenden Erfindung;
- Fig. 11: eine schematische Ansicht einer Blende und eines Fensters nach dem Zusammenfügen gemäß einem weiteren Ausführungsbeispiel der vorliegenden Erfindung;
- Fig. 12: eine schematische Ansicht einer Blende, eines Einfallfensters und eines Ausfallfensters gemäß einem Ausführungsbeispiel der vorliegenden Erfindung;
- Fig. 13: eine schematische Ansicht einer Blende, eines Einfallfensters und eines Ausfallfensters nach dem Zusammenfügen gemäß einem Ausführungsbeispiel der vorliegenden Erfindung;
- Fig. 14: eine schematische Ansicht eines Projektionssystems mit einem Gehäuse zu Verkapselung eines Mikroscannerspiegels gemäß einem Ausführungsbeispiel der vorliegenden Erfindung;
- Fig. 15: eine schematische Ansicht einer Blende, eines Einfallfensters und eines Ausfallfensters nach dem Zusammenfügen gemäß einem Ausführungsbeispiel der vorliegenden Erfindung;
- Fig. 16: eine schematische Ansicht eines Substrats mit einer Mehrzahl von Gehäusen zur Verkapselung von Mikroscannerspiegeln gemäß einem Ausführungsbeispiel der vorliegenden Erfindung;
- Fig. 17: ein Diagramm einer normierten Reflexion eines einfallenden Lichtstrahls entlang einer Oberfläche eines Gehäuses zur Verkapselung eines Mikroscannerspiegels gemäß einem Ausführungsbeispiel der vorliegenden Erfindung;
- Fig. 18: eine schematische Ansicht eines herkömmlichen Gehäuses zur Verkapselung eines Mikroscannerspiegels;
- Fig. 19: eine schematische Ansicht eines herkömmlichen Gehäuses zur Verkapselung eines Mikroscannerspiegels;
- Fig. 20: eine schematische Ansicht eines herkömmlichen Gehäuses zur Verkapselung eines Mikroscannerspiegels bei dem das Glasfenster relativ zu einer Spiegelebene des Mikroscannerspiegels gekippt ist;
- Fig. 21: eine schematische Ansicht einer herkömmlichen Glasscheibe sowie der parasitären Reflexionen, die an der Oberseite und Unterseite der Glasscheibe durch einen einfallenden Lichtstrahl hervorgerufen werden;
- Fig. 22: eine schematische Ansicht einer herkömmlichen Glasscheibe und einer herkömmlichen Blende zur Unterdrückung parasitärer Reflexionen; und
- Fig. 23: eine schematische Ansicht einer herkömmlichen Glasscheibe und einer herkömmlichen Blende zur Unterdrückung parasitärer Reflexionen.

In der nachfolgenden Beschreibung werden in den Figuren gleiche oder gleichwirkende Elemente mit den gleichen Bezugszeichen versehen, so dass deren Beschreibung in den unterschiedlichen Ausführungsbeispielen untereinander austauschbar ist.

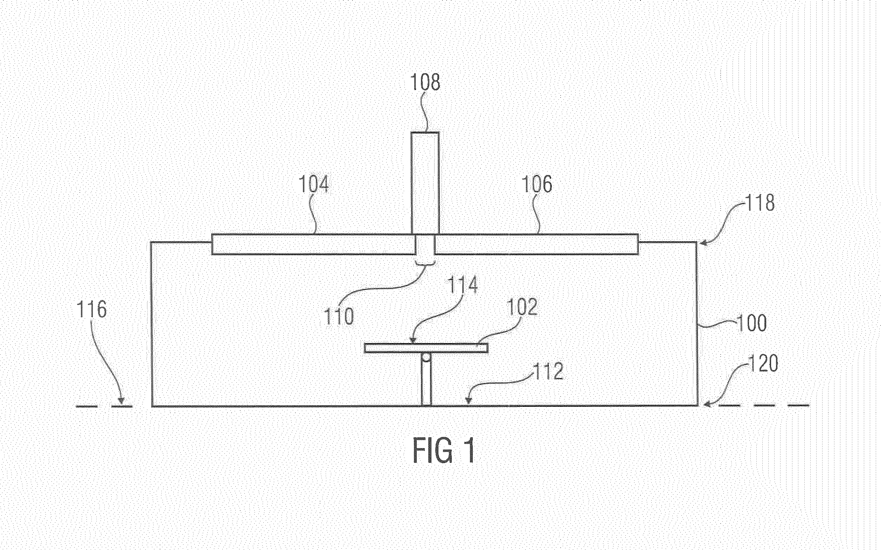

Fig. 1 zeigt eine schematische Ansicht eines Gehäuses 100 zur Verkapselung eines Mikroscannerspiegels 102 gemäß einem Ausführungsbeispiel der vorliegenden Erfindung. Das Gehäuse 100 weist einen Einfallfensterbereich 104, einen Ausfallfensterbereich 106 und eine Blende 108 auf, wobei der Einfallfensterbereich 104 und der Ausfallfensterbereich 106 in einem vorbestimmten Bereich 110 zumindest teilweise voneinander getrennt sind, in dem die Blende 108 angeordnet ist.

Gemäß dem Konzept der vorliegenden Erfindung können parasitäre Reflexionen eines einfallenden Lichtstrahls dadurch vermindert bzw. reduziert werden, dass der Einfallfensterbereich 104 und der Ausfallfensterbereich 106 in dem vorbestimmten Bereich 110, in dem die Blende 108 angeordnet ist, zumindest teilweise voneinander getrennt sind.

Wie in Fig. 1 gemäß einem Ausführungsbeispiel dargestellt ist, können der Einfallfensterbereich 104 und der Ausfallfensterbereich 106 in dem vorbestimmten Bereich voneinander (vollständig) getrennt sein, in dem die Blende 108 angeordnet ist.

Mit anderen Worten, Fig. 1 zeigt ein Gehäuse 100 zur Verkapselung eines Mikroscannerspiegels 102 gemäß einem Ausführungsbeispiel der vorliegenden Erfindung. Das Gehäuse 100 weist einen Einfallfensterbereich 104, einen Ausfallfensterbereich 106 und eine Blende 108 auf, wobei der Einfallfensterbereich 104 und der Ausfallfensterbereich 106 in einem vorbestimmten Bereich 110 voneinander getrennt sind, in dem die Blende 108 angeordnet ist.

Bei Ausführungsbeispielen kann das Gehäuse 100 eine Bodenstruktur 112 aufweisen, die ausgebildet ist, um den Mikroscannerspiegel 102 beweglich zu tragen, wobei der Einfallfensterbereich 104 und der Ausfallfensterbereich 106 parallel zu der Bodenstruktur 112 angeordnet sein können.

Beispielsweise kann das Gehäuse 100 eine Oberseite 118 und eine Unterseite 120 aufweisen. Die Oberseite 118 des Gehäuses 100 kann den Einfallfensterbereich 104 und den Ausfallfensterbereich 106 aufweisen. Die Unterseite 120 des Gehäuses 100 kann die Bodenstruktur 112, wie z.B. eine Bodenplatte, aufweisen. Die Oberseite 118 und die Unterseite 120 des Gehäuses 100 können parallel zueinander angeordnet sein, so dass der Einfallfensterbereich 104 und der Ausfallfensterbereich 106 parallel zu der Unterseite 120 des Gehäuses 100 angeordnet sind. Ferner können der Einfallfensterbereich 104 und der Ausfallfensterbereich 106 in einer gemeinsamen Ebene (z.B. Oberseite 118) angeordnet sein oder parallel zu der gemeinsamen Ebene angeordnet sein.

Ferner können der Einfallfensterbereich 104 und der Ausfallfensterbereich 106 in einer Ruheposition des Mikroscannerspiegels 102 parallel zu einer Oberfläche 114 des Mikroscannerspiegels 102 angeordnet sein. Die Oberfläche 114 des Mikroscannerspiegels 102 kann die Spiegelfläche bzw. spiegelnde Fläche (Spiegelebene) des Mikroscannerspiegels 102 sein.

Des Weiteren kann das Gehäuse 100 auf einem Substrat 116 gebildet sein, wobei der Einfallfensterbereich 104 und der Ausfallfensterbereich 106 parallel zu dem Substrat 116 angeordnet sein können.

Darüber hinaus können die Blende 108, der Einfallfensterbereich 104 und der Ausfallfensterbereich 106 zumindest einen Teil einer Deckenstruktur des Gehäuses 100 bilden. Mit anderen Worten, die Oberseite 118 des Gehäuses 100 kann eine Deckenstruktur aufweisen, wobei die Deckenstruktur die Blende 108, den Einfallfensterbereich 104 und den Ausfallfensterbereich 106 aufweisen kann.

Wie in Fig. 1 gemäß einem Ausführungsbeispiel gezeigt ist, können der Einfallfensterbereich 104 und der Ausfallfensterbereich 106 durch einen Schlitz 110 in dem vorbestimmten Bereich 110 voneinander getrennt sein.

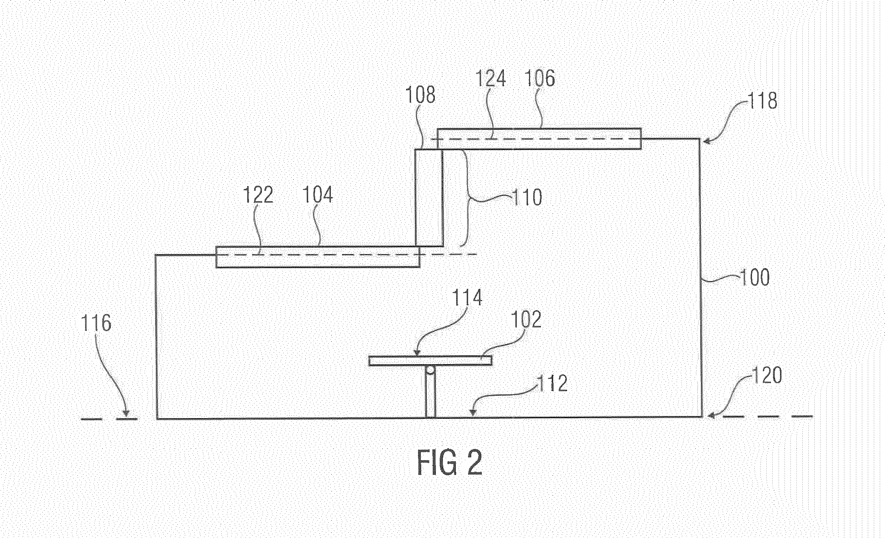

Fig. 2 zeigt eine schematische Ansicht eines Gehäuses 100 zur Verkapselung eines Mikroscannerspiegels 102 gemäß einem weiteren Ausführungsbeispiel der vorliegenden Erfindung. Im Vergleich zu Fig. 1 sind der Einfallfensterbereich 104 und der Ausfallfensterbereich 106 dadurch in dem vorbestimmten Bereich 110 voneinander getrennt, dass der Einfallfensterbereich 104 in einer Einfallebene 122 und der Ausfallfensterbereich 106 in einer Ausfallebene 124 angeordnet sind, wobei die Einfallebene 122 und die Ausfallebene 124 parallel zueinander verlaufen.

Wie in Fig. 2 gemäß einem Ausführungsbeispiel gezeigt ist, kann ein Abstand zwischen der Ausfallebene 124 und dem Mikroscannerspiegel 102 größer sein als ein Abstand zwischen der Einfallebene 122 und dem Mikroscannerspiegel 102.

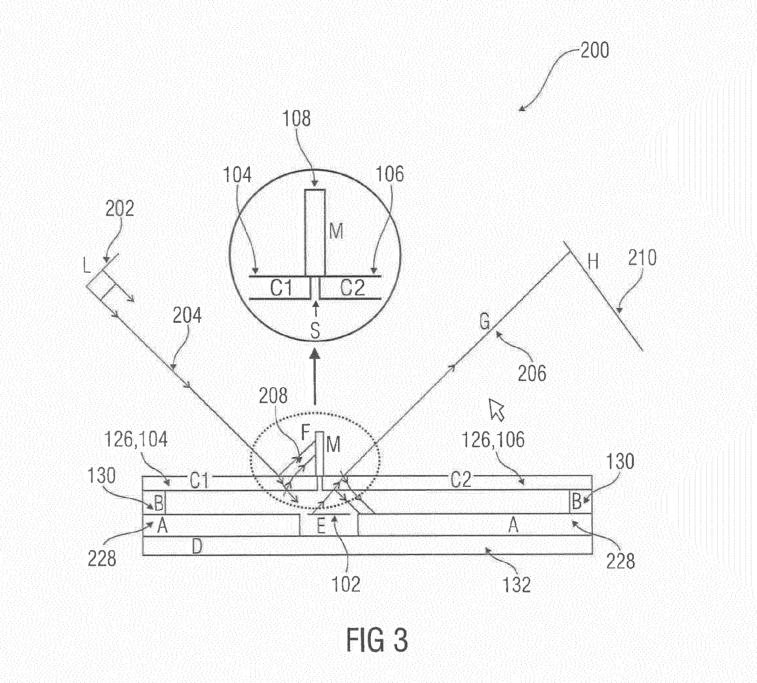

Fig. 3 zeigt eine schematische Ansicht eines Projektionssystems 200 gemäß einem Ausführungsbeispiel der vorliegenden Erfindung. Das Projektionssystem 200 weist das in Fig. 1 gezeigte Gehäuse 100 zur Verkapselung eines Mikroscannerspiegels 102 und eine Lichtquelle 202 zum emittieren eines Lichtstrahls 204 auf. Die Lichtquelle 202 und das Gehäuse 100 können derart zueinander angeordnet sein, dass ein Nutzteil 206 des Lichtstrahls 204 auf den Mikroscannerspiegel 102 trifft und von dem Mikroscannerspiegel 102 in Richtung des Ausfallfensterbereichs 106 reflektierte wird, und das ein parasitärer Teil 208 des Lichtstrahls 204, der von dem Einfallfensterbereich 104 reflektiert wird, auf die Blende 108 trifft.

Wie in Fig. 3 gemäß einem Ausführungsbeispiel gezeigt ist, kann der von dem Mikroscannerspiegel 102 reflektierte Nutzteil 206 des Lichtstrahls 204 durch den Ausfallfensterbereich 106 hindurch auf eine Projektionsfläche 210, wie z.B. eine Leinwand oder ein Detektor, treffen.

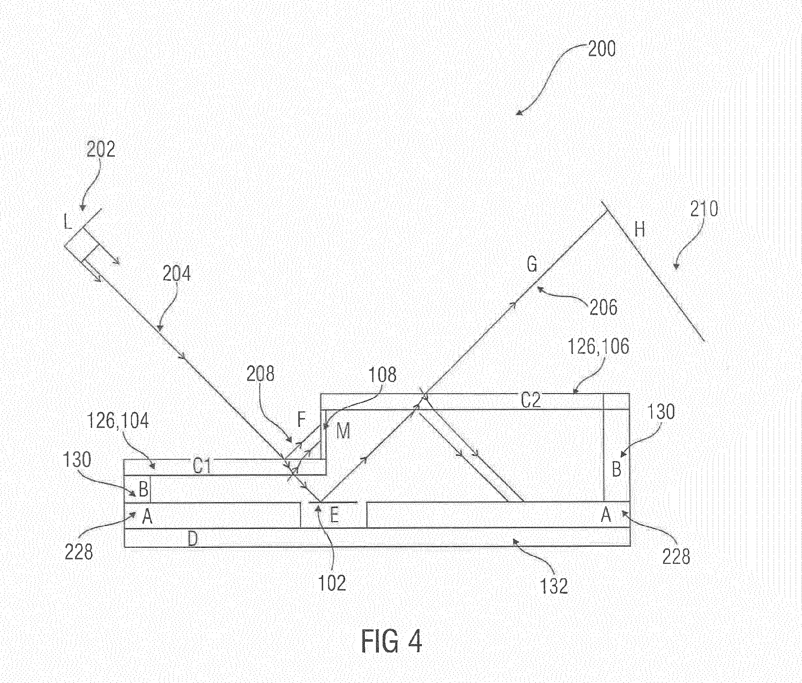

Fig. 4 zeigt eine schematische Ansicht eines Projektionssystems 200 gemäß einem weiteren Ausführungsbeispiel der vorliegenden Erfindung. Im Vergleich zu Fig. 3 weist das Projektionssystem 200 das in Fig. 2 gezeigte Gehäuse 100 zur Verkapselung des Mikroscannerspiegels 102 auf.

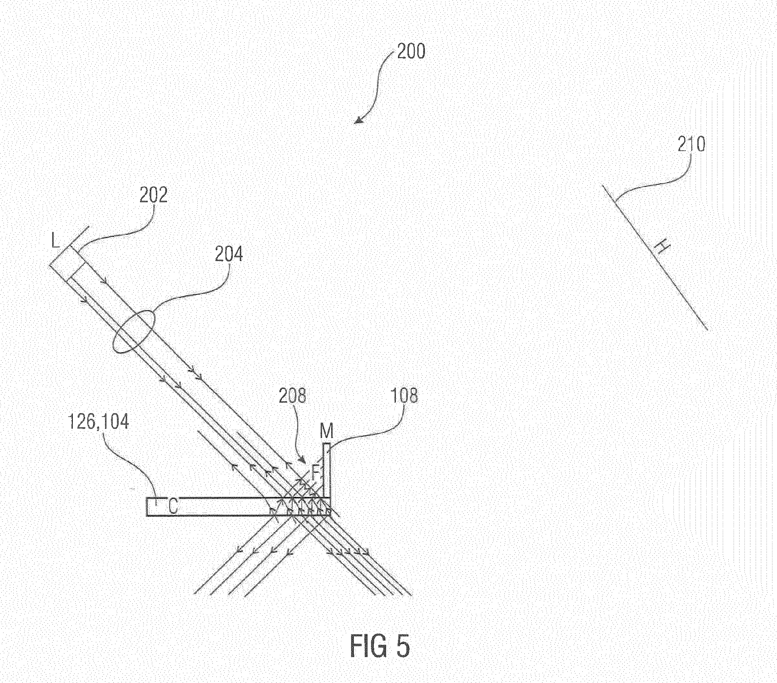

Gemäß dem Konzept der vorliegenden Erfindung können die parasitären Reflexionen 208 bis auf 0% (oder 0,1 %, 0,2 %, 0,3 %, 0,4% oder 0,5%) reduziert werden, wenn die Glasscheibe, die den Einfallfensterbereich 104 und den Ausfallfensterbereich 106 aufweisen kann, (genau) unter der Blende 108 abgeschnitten wird, weil dann "der Wellenleiter" nicht mehr vorhanden ist, wie dies aus der nachfolgenden Fig. 5 hervorgeht.

Fig. 5 zeigt eine schematische Ansicht einer Glasscheibe 126 und einer Blende 108, wobei die Glasscheibe 126 unterhalb der Blende 108 abgeschnitten ist. Mit anderen Worten, Fig. 5 zeigt eine (totale) Unterdrückung der parasitären Reflexionen 208 mit einer Blende 108 und abgekürzter Glasscheibe 126.

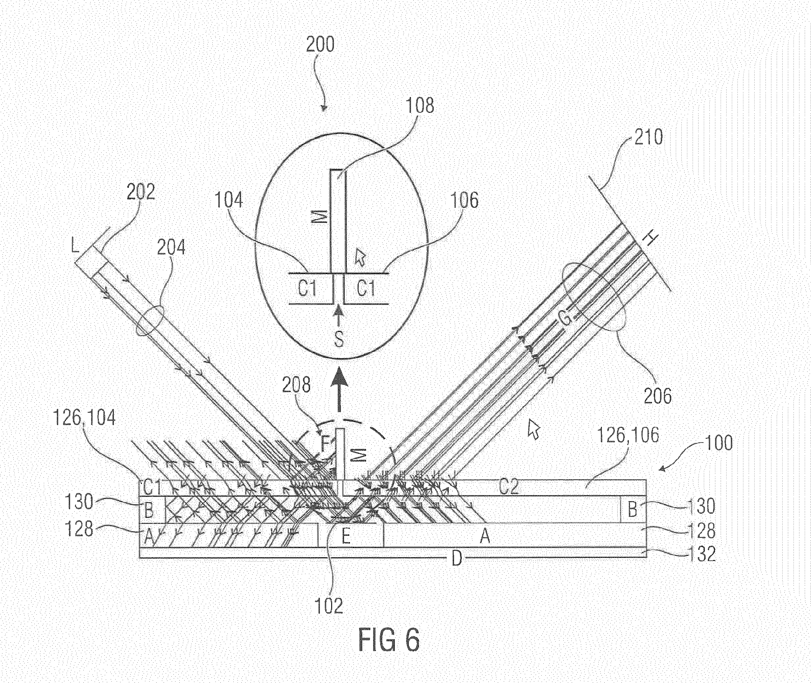

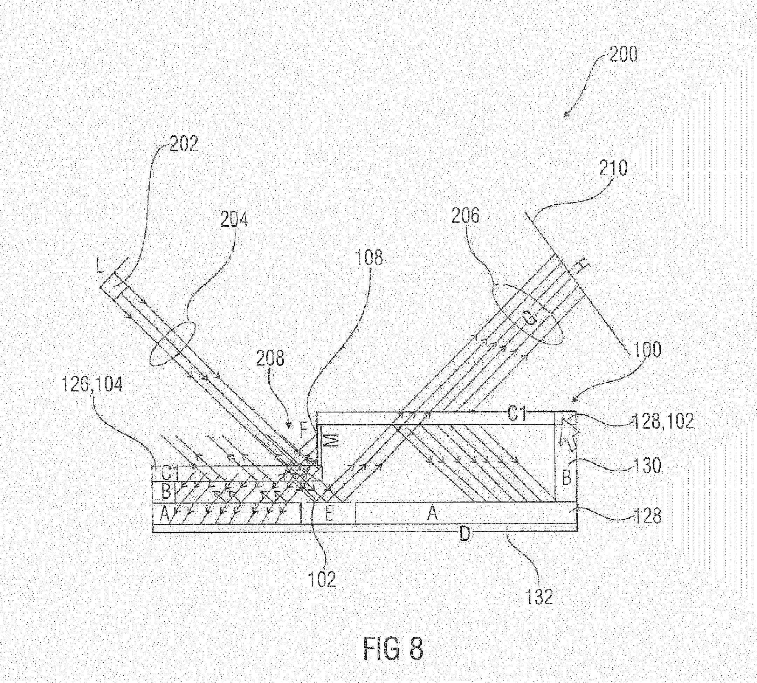

Im Folgenden werden zwei Strukturen für die Verkapselung von Mikroscannerspiegeln 102 unter Verwendung der in Fig. 5 gezeigten Struktur beschrieben. Zum einen eine Struktur, bei der das Glasfenster (Wellenleiter) durch einen Spalt 110 in der Glasscheibe 126 unterbrochen ist (Fig. 6). Zum Anderen eine Struktur, bei der das Glasfenster (Wellenleiter) durch eine Schichtstruktur (engl.: sandwich structure) unterbrochen ist, wie z.B. eine strukturierte Silizium-Scheibe zwischen zwei strukturierten Glasscheiben (Fig. 8).

Fig. 6 zeigt eine schematische Ansicht eines Projektionssystems 200 mit einem Gehäuse 100 zur Verkapselung eines Mikroscannerspiegels 102 gemäß einem Ausführungsbeispiel der vorliegenden Erfindung. Das Gehäuse 100 weist den Einfallfensterbereich 104, den Ausfallfensterbereich 106 und die Blende 108 auf, wobei der Einfallfensterbereich 104 und der Ausfallfensterbereich in dem vorbestimmten Bereich 110 voneinander getrennt sind, in dem die Blende 108 angeordnet ist. Das Gehäuse 100 kann ein Fenster (z.B. eine Glasscheibe) 126 aufweisen, die den Einfallfensterbereich 104 und den Ausfallfensterbereich 106 aufweist, wobei der Einfallfensterbereich 104 und der Ausfallfensterbereich 106 durch einen Schlitz 110 (in dem Fenster 126) voneinander getrennt bzw. beanstandet sind.

Bei manchen Ausführungsbeispielen kann auf einem Mikrospiegelchip 128 (A), z.B. aus Silizium, ein Abstandshalter (engl.: spacer) 130 (B) gebondet werden. Auf dem Abstandshalter 130 kann das Glasfenster 126 (C) aufgebracht bzw. gebondet sein. Ferner kann auf einer Rückseite des Chips 128 ein Unterdeckel 132 (D), z.B. ein Silizium Unterdeckel, gebondet sein, so dass der Mikroscannerspiegel 102 (E) keinen direkten Kontakt mit der Umwelt mehr hat, bzw. unter umstanden in Vakuum verkapselt ist.

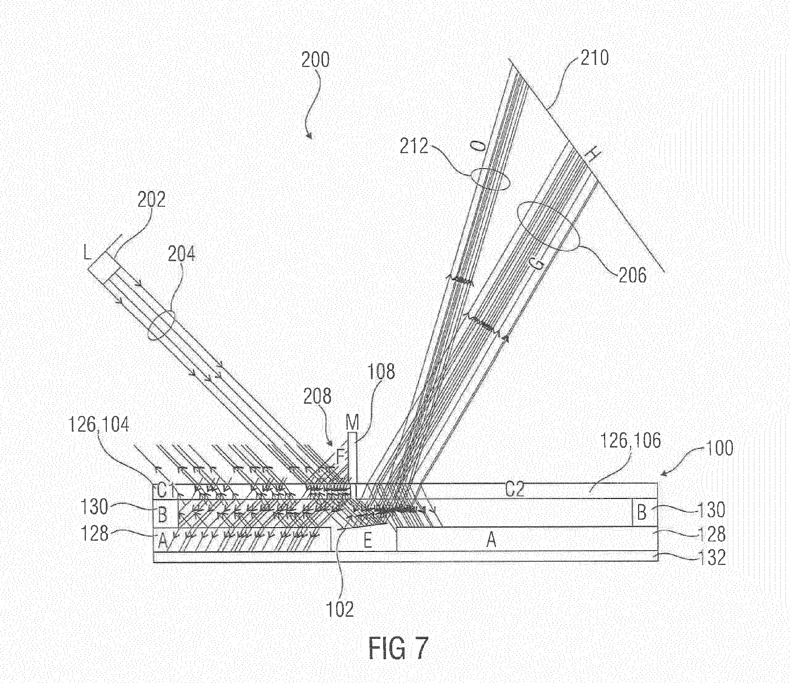

Die Unterbrechung des Glasfensters 126 zusammen mit der Blende 108 resultiert in einer reduzierten (oder sogar völligen) Unterdrückung der parasitären Reflexionen 208 (F). Der Abstand zwischen Spiegelebene 114 (A) und Glasfenster 126 (C) (d.h. Dicke des Abstandshalters 130 (B)) kann abhängig von einer Winkelamplitude (z.B. maximaler Kippwinkel) des Mikroscannerspiegels 102 gewählt werden. Wenn der Abstandshalter 130 (B) zu dünn ist und der Kippwinkel des Mikroscannerspiegels 102 zu groß ist, dann können "Rausch Reflexionen" auftreten, wie dies anhand der nachfolgenden Fig. 7 gezeigt wird.

Fig. 7 zeigt eine schematische Ansicht eines Projektionssystemen 200 mit einem Gehäuse 100 zur Verkapselung eines Mikroscannerspiegels 102 bei dem Rausch Reflexionen 212 bedingt durch einen zu geringen Abstand zwischen Glasfenster und Spiegelebene auftreten. Wenn der Abstand zwischen Spiegelebene 114 und Glasfenster 126 zu niedrig ist, können Rauschreflexionen 212 entstehen. Um die Rausch Reflexionen 212 zu vermeiden kann die Glasscheibe 126 weiter weg von der Spiegelebene 114 angeordnet werden, wodurch das Gehäuse 100 (z.B. Chip) jedoch größer wird.

Weil die Rausch-Reflexionen 212 von dem Ausfallfensterbereich 106 (Ausgangsfenster) generiert werden, wäre eine Alternative für die Vermeidung von Rausch-Reflexionen 212 nur den Ausfallfensterbereich 106 (Ausgangsfenster) von der Spiegelebene 114 zu entfernen, den Einfallfensterbereich 104 (Eingangsfenster) jedoch so nah wie möglich an der Spiegelebene 114 anzuordnen. Zwischen dem Einfallfensterbereich 104 (Eingangsfenster) und dem Ausfallfensterbereich 106 (Ausgangsfenster) kann die Blende 108 platziert werden, wie dies in der nachfolgenden Fig. 8 gezeigt ist.

Fig. 8 zeigt ein Projektionssystem 200 mit einem Gehäuse 100 zur Verkapselung eines Mikroscannerspiegels 102 gemäß einem Ausführungsbeispiel der vorliegenden Erfindung. Das Gehäuse weist den Einfallfensterbereich 104, den Ausfallfensterbereich 106 und die Blende 108 auf, wobei der Einfallfensterbereich 104 und der Ausfallfensterbereich in dem vorbestimmten Bereich 110 voneinander getrennt sind, in dem die Blende 108 angeordnet ist. Der Einfallfensterbereich 104 und der Ausfallfensterbereich 106 können dadurch in dem vorbestimmten Bereich 110 voneinander getrennt sein, dass der Einfallfensterbereich 104 in einer Einfallebene 122 und der Ausfallfensterbereich 106 in einer Ausfallebene 124 angeordnet sind, wobei ein Abstand zwischen der Ausfallebene 124 und dem Mikroscannerspiegel 102 größer ist als ein Abstand zwischen der Einfallebene 122 und dem Mikroscannerspiegel 102. Ferner kann das Gehäuse 100 ein Einfallfenster 126 und ein Ausfallfenster 128 aufweisen, wobei das Einfallfenster 126 (C1) den Einfallfensterbereich 104 und das Ausfallfenster 128 (C2) den Ausfallfensterbereich 106 aufweisen kann, wobei die Blende 108 zwischen dem Einfallfenster 126 und dem Ausfallfenster 128 angeordnet sein kann.

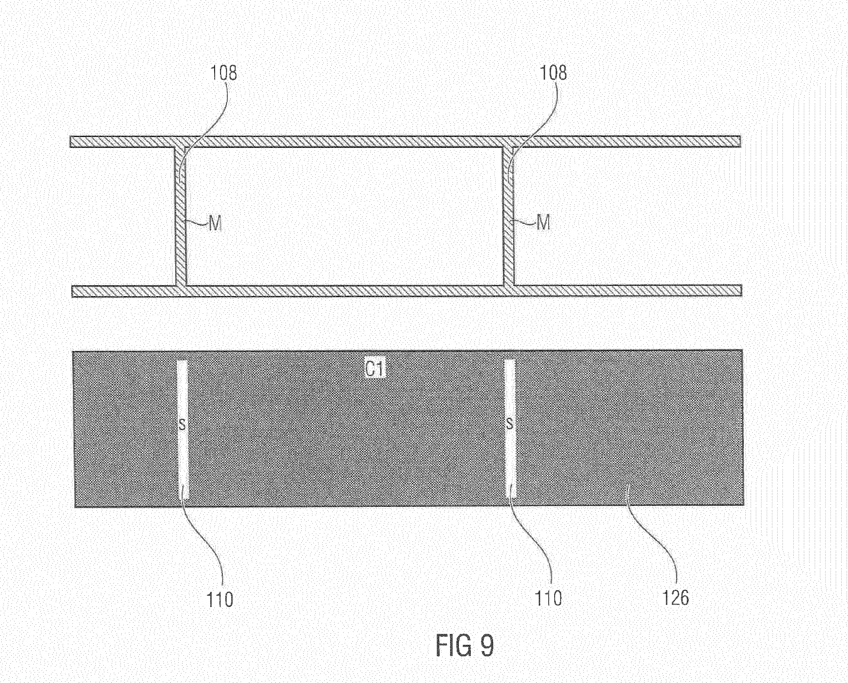

Fig. 9 zeigt eine schematische Ansicht einer Blende 108 und eines Fensters 126 gemäß einem Ausführungsbeispiel der vorliegenden Erfindung. Die Blende 108 und das Fenster 126 können zur Realisierung des in Fig. 1 oder Fig. 6 gezeigten Gehäuses 100 zur Verkapselung eines Mikroscannerspiegels 102 verwendet werden.

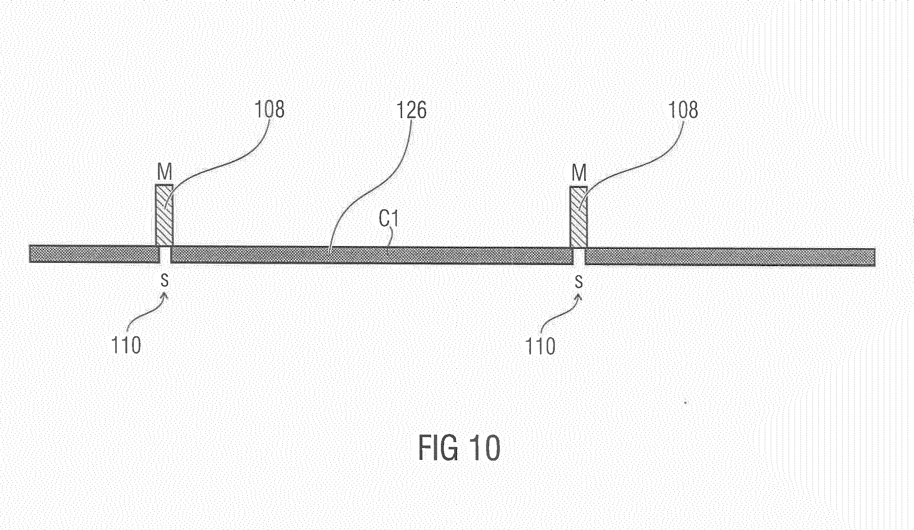

Bei Ausführungsbeispielen können die Scheiben mit den Blenden 108 und das Glas 126 so wie in Fig. 9 dargestellt ist, realisiert werden. Die Scheibe mit den Blenden 108 kann aus Silizium sein, deshalb kann sie einfach mit Standard Strukturierungstechniken (Trocken- oder Nassätzung) realisiert werden. Bei der Glasscheibe 126 können rechteckige Schlitze durchstrukturiert werden. Dafür kann z.B. Ultraschallbohren verwenden werden. Andere Alternativen sind Sandstrahlen oder Diamantbohren. Nach der Strukturierung können die Scheiben zusammen gebondet werden, wie in der nachfolgenden Fig. 10 gezeigt wird.

Fig. 10 zeigt eine schematische Ansicht einer Blende 108 und eines Fensters 126 nach dem Zusammenfügen gemäß einem Ausführungsbeispiel der vorliegenden Erfindung. Mit anderen Worten, nach der Strukturierung können die Scheiben zusammen gebondet werden, so dass die finale Struktur wie in Fig. 10 aussieht. Die Bondmethode kann eine vakuumkompatible Methode sein (z.B. anodisch oder Glas Frit (Glas-Löten, Glas-Abdichtbonden)), so dass die finale Struktur für Vakuumverkapselung verwendet werden kann.

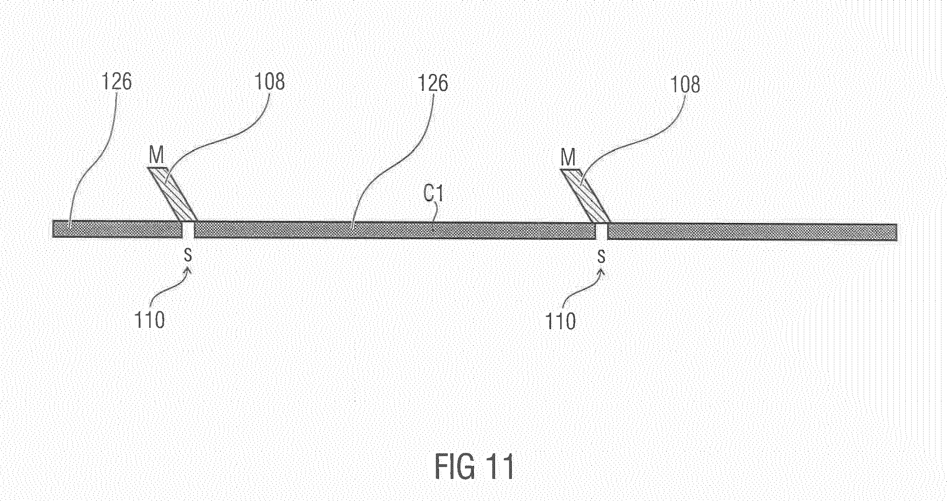

Fig. 11 zeigt eine schematische Ansicht einer Blende 108 und eines Fensters 126 nach dem Zusammenfügen gemäß einem weiteren Ausführungsbeispiel der vorliegenden Erfindung. Wie in Fig. 11 gezeigt ist, können die Blenden auch gekippt strukturiert werden, so dass der gleiche Effekt bei der Abschattung des Lichtes realisiert wird, aber die Struktur insgesamt um 100 - 200 µm dünner wird. Wie schon erwähnt, sind dünne Strukturen für die mobile Anwendungen von Vorteil.

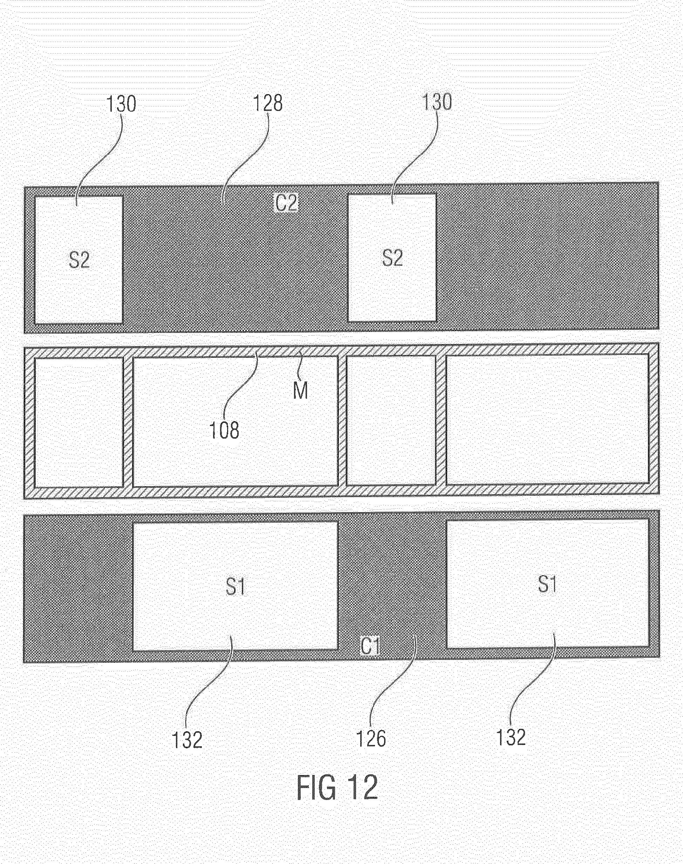

Fig. 12 zeigt eine schematische Ansicht einer Blende 108, eines Einfallfensters 126 und eines Ausfallfensters 128 gemäß einem Ausführungsbeispiel der vorliegenden Erfindung. Die Blende 108, das Einfallfenster 126 und das Ausfallfenster 128 können dabei zur Realisierung des in Fig. 2 oder Fig. 8 gezeigten Gehäuses 100 zur Verkapselung eines Mikroscannerspiegels 102 verwendet werden.

Mit anderen Worten, Fig. 12 zeigt eine Struktur für die Vermeidung von parasitären Reflexionen 208 mit zwei Glasscheiben 126 und 128 mit einem Abstandshalter (engl.: spacer, interposer) dazwischen. Die untere Glasscheibe 126 kann als Eingangsfenster 126 und die obere Glasscheibe 128 als Ausgangsfenster 128 verwendet werden. Der Abstandshalter ist in diesem Fall die notwendige Blende 108 für das Licht und kann nicht transparent für nutzbares (in diesem Fall sichtbares) Licht sein, z.B. aus Silizium. Sowohl die zwei Glasscheiben 126 und 128 als auch die Silizium-Scheibe (Abstandshalter) 108 können strukturiert werden und dann miteinander zusammen gebondet werden, z.B. anodisch. Die Strukturierung reduziert sich in diesem Fall nur auf die Bohrung von Löchern 130 (S1) und 132 (S2) in die Glasscheiben 126 und 128. Weil die Löcher in Millimeter Bereich sind, können etablierte Methoden wie, Ultraschallbohren dafür verwenden werden. Andere alternativen wären Sandstrahlen oder Diamantbohren oder Plasmaätzen/Nassätzen.

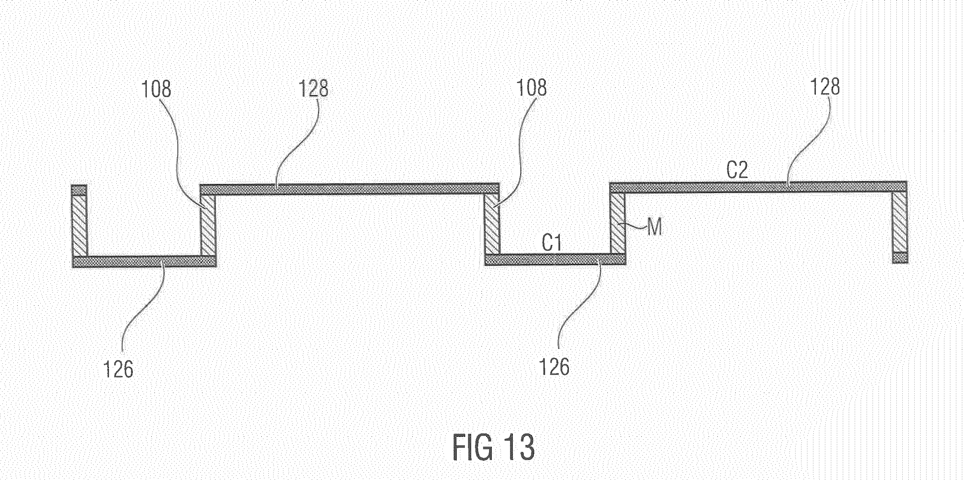

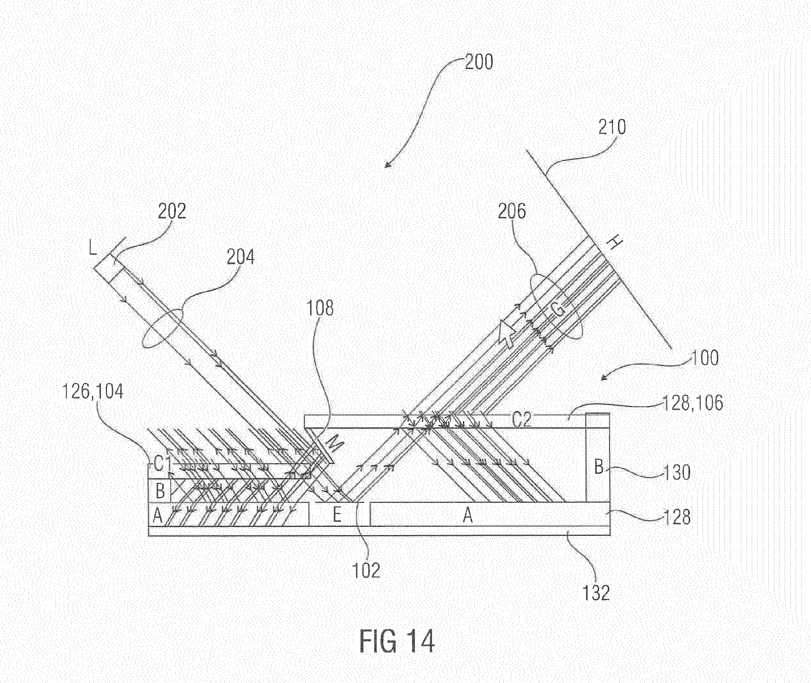

Fig. 13 zeigt eine schematische Ansicht einer Blende 108, eines Einfallfensters 126 und eines Ausfallfensters 128 nach dem Zusammenfügen gemäß einem Ausführungsbeispiel der vorliegenden Erfindung. Mit anderen Worten, Fig. 13 zeigt die finale Struktur im Querschnitt. Analog zu Fig. 11 kann die Blende auch gekippt strukturiert werden, um den gleichen Effekt bei der Abschaltung mit einer dünnen finalen Struktur zu erhalten. Wie diese Struktur für die Vermeidung von parasitären Reflexionen 208 eingesetzt werden kann, wird anhand der nachfolgenden Fig. 14 gezeigt.

Fig. 14 zeigt eine schematische Ansicht eines Projektionssystems 200 mit einem Gehäuse 100 zu Verkapselung eines Mikroscannerspiegels 102 gemäß einem Ausführungsbeispiel der vorliegenden Erfindung. Im Vergleich zu Fig. 8 ist die Blende 108 schräg angeordnet. Mit anderen Worten, Fig. 14 zeigt eine gekippte Blende 108, um die Dicke des Gehäuses 100 (z.B. Chip) zu reduzieren.

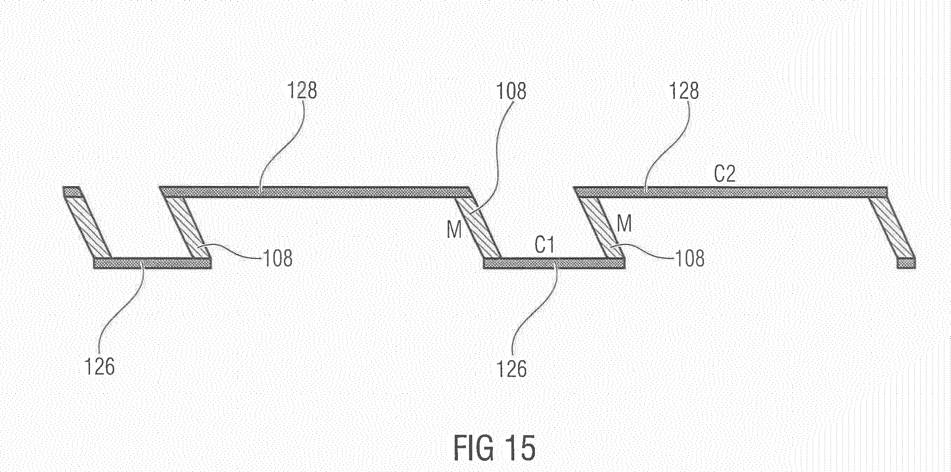

Fig. 15 zeigt eine schematische Ansicht einer Blende 108, eines Einfallfensters 126 und eines Ausfallfensters 128 nach dem Zusammenfügen gemäß einem Ausführungsbeispiel der vorliegenden Erfindung. Die Blende 108 ist bezogen auf den Einfallfensterbereich 104 und/oder den Ausfallfensterbereich 106 gekippt angeordnet.

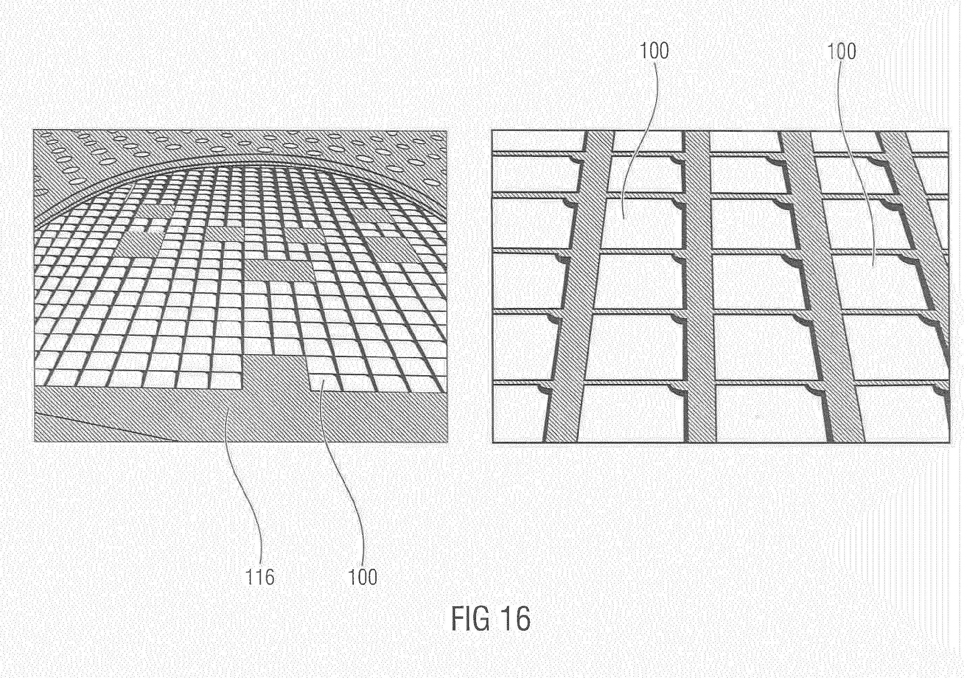

Fig. 16 zeigt ein Foto eines Substrats 116 mit einer Mehrzahl von Gehäusen 100 zur Verkapselung von Mikroscannerspiegeln 102 gemäß einem Ausführungsbeispiel der vorliegenden Erfindung. Mit anderen Worten, Fig. 16 zeigt gekippte Blendenstrukturen auf sechs Zoll Wafern 116. Die sechs Zoll Scheibe 116 mit gekippten Blenden 108 kann mit einer Glasscheibe zusammen gebondet werden, um eine ähnliche Struktur zu realisieren, wie die in Fig. 10 gezeigte (aber ohne den Spalt S).

Fig. 17 zeigt ein Diagramm einer Reflexion (real gemessen, nicht Simuliert) eines einfallenden Lichtstrahls 204 entlang einer Oberfläche eines Gehäuses 100 zur Verkapselung eines Mikroscannerspiegels 102. Die Ordinate beschreibt dabei die normierte Reflexion, während die Abszisse eine Wegstrecke entlang der Oberfläche des Gehäuses 100 in mm beschreibt. Mit anderen Worten, Fig. 17 zeigt optische Messungen von einer Struktur wie sie in Fig. 10 dargestellt ist (mit einer unter 35° gekippten Blende). Die parasitären Reflexionen 108 können bis auf 0,02 normiert (siehe Fig. 17) oder 2 % von den parasitären Reflektionen 208 ohne Blende 108 reduziert werden. Das ist weniger als 0,2 % der eingesetzten Leistung der Lichtquelle 202 (Laser). Der Rest von 0.2% von den parasitären Reflexionen kommt von dem Wellenleitereffekt und kann komplett eliminiert werden (oder zumindest reduziert werden), z.B. durch eine Strukturierung des Glases wie in Fig. 10 und Fig. 11 dargestellt ist.

Im Gegensatz zu herkömmlichen Strukturen, muss gemäß dem Konzept der vorliegenden Erfindung das Glasfenster 126 (oder Eingangsfenster 126 und Ausgangsfenster 128) für die Vermeidung von parasitären Reflexionen nicht gekippt werden, d.h. das Glasfenster 126 (oder Eingangsfenster 126 und Ausgangsfenster 128) können parallel zur Spiegelebene bleiben. Dies hat folgende Vorteile. Erstens ist keine aufwendige Glasstrukturierung des Glases erforderlich, um die Fenster zu kippen. Zweitens ist kein extra Rahmen in Design erforderlich, um die Spiegelebene relativ zu dem Glasfenster permanent zu kippen. Drittens sind die Stellen wo das Licht eingeht oder ausgeht nicht strukturiert, d.h. diese haben die optische Qualität der ursprünglichen Glasscheibe. Viertens wird das Bonden vereinfacht, da nur ebene Wafer verwendet werden und keine Spitzen auf dem Bond-Chuck abbrechen können.

Weitere Ausführungsbeispiele beziehen sich auf eine Methode für die Vermeidung von parasitären Reflexionen bei der Verkapselung von Mikroscannerspiegeln durch eine Blende, die auf eine geschlitzte Silizium-Scheibe gebondet wird.

Weitere Ausführungsbeispiele beziehen sich auf eine Methode für die Vermeidung von parasitären Reflexionen bei der Verkapselung von Mikroscannerspiegeln durch eine unter einem vorgegebenen (bestimmten) Winkel gekippte Blende, die auf eine geschlitzte Silizium-Scheibe gebondet wird.

Weitere Ausführungsbeispiele beziehen sich auf eine Methode für die Vermeidung von parasitären Reflexionen bei der Verkapselung von Mikroscannerspiegeln durch eine Blende, die sich zwischen zwei strukturierte Glas Scheiben befindet.

Weitere Ausführungsbeispiele beziehen sich auf eine Methode für die Vermeidung von parasitären Reflexionen bei der Verkapselung von Mikroscannerspiegeln durch einer unter einem Winkel gekippte Blende, die sich zwischen zwei strukturierten Glasscheiben befindet.

Weitere Ausführungsbeispiele beziehen sich auf ein Gehäuse, bei dem das Glas nicht komplett durchgeätzt ist, sondern nur zur Hälfte oder zu zweidrittel. So wird auch die parasitäre Reflexion um die Hälfte oder zu zweidrittel reduziert. Abhängig von dem Produkt, könnte diese partielle Reduzierung ausreichend sein.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Gehäuse (100) zur Verkapselung eines Mikroscannerspiegels (102), wobei das Gehäuse (100) einen Einfallfensterbereich (104) für einen in das Gehäuse (100) einfallenden Lichtstrahl (204), einen Ausfallfensterbereich (106) für einen aus dem Gehäuse (100) ausfallenden Lichtstrahl (206), und eine Blende (108) zur Unterdrückung eines parasitären Teils (208) des einfallenden Lichtstrahls (204), der von dem Einfallfensterbereich (104) reflektiert wird, aufweist, wobei der Einfallfensterbereich (104) und der Ausfallfensterbereich (106) in einem vorbestimmten Bereich (110) zumindest teilweise voneinander getrennt sind, in dem die Blende (108) angeordnet ist, wobei der Einfallfensterbereich (104) und der Ausfallfensterbereich (106) durch einen Schlitz (110) in dem vorbestimmten Bereich (110) voneinander getrennt sind.

2. Gehäuse (100) nach Anspruch 1, wobei das Gehäuse (100) ein Fenster (126) aufweist, wobei das Fenster (126) den Einfallfensterbereich (104), den Ausfallfensterbereich (106) und den Schlitz (110) aufweist, wobei die Blende (110) benachbart zu dem Schlitz (110) angeordnet ist.

3. Gehäuse (100) zur Verkapselung eines Mikroscannerspiegels (102), wobei das Gehäuse (100) einen Einfallfensterbereich (104) für einen in das Gehäuse (100) einfallenden Lichtstrahl (204), einen Ausfallfensterbereich (106) für einen aus dem Gehäuse (100) ausfallenden Lichtstrahl (206), und eine Blende (108) zur Unterdrückung eines parasitären Teils (208) des einfallenden Lichtstrahls (204), der von dem Einfallfensterbereich (104) reflektiert wird, aufweist, wobei der Einfallfensterbereich (104) und der Ausfallfensterbereich (106) in einem vorbestimmten Bereich (110) zumindest teilweise voneinander getrennt sind, in dem die Blende (108) angeordnet ist, wobei der Einfallfensterbereich (104) und der Ausfallfensterbereich (106) dadurch in dem vorbestimmten Bereich (110) voneinander getrennt sind, dass der Einfallfensterbereich (104) in einer Einfallebene (122) und der Ausfallfensterbereich (106) in einer Ausfallebene (124) angeordnet sind, wobei die Einfallebene (122) und die Ausfallebene (124) parallel zueinander verlaufen und voneinander beabstandet sind.

4. Gehäuse (100) nach Anspruch 3, wobei ein Abstand zwischen der Ausfallebene (124) und dem Mikroscannerspiegel (102) größer ist als ein Abstand zwischen der Einfallebene (122) und dem Mikroscannerspiegel (102).

5. Gehäuse (100) nach Anspruch 3 oder 4, wobei das Gehäuse (100) ein Einfallfenster (126) und ein Ausfallfenster (128) aufweist, wobei das Einfallfenster (126) den Einfallfensterbereich (104) und das Ausfallfenster (128) den Ausfallfensterbereich (106) aufweist, wobei die Blende (108) zwischen dem Einfallfenster (126) und dem Ausfallfenster (128) angeordnet ist.

6. Gehäuse (100) nach einem der Ansprüche 1 bis 5, wobei das Gehäuse (100) eine Bodenstruktur (112) aufweist, die ausgebildet ist, um den Mikroscannerspiegel (102) beweglich zu tragen, und wobei der Einfallfensterbereich (104) und der Ausfallfensterbereich (106) parallel zu der Bodenstruktur (112) angeordnet sind.

7. Gehäuse (100) nach einem der Ansprüche 1 bis 6, wobei der Einfallfensterbereich (104) und der Ausfallfensterbereich (106) in einer Ruheposition des Mikroscannerspiegels (102) parallel zu einer Oberfläche (114) des Mikroscannerspiegels (102) angeordnet sind.

8. Gehäuse (100) nach einem der Ansprüche 1 bis 7, wobei das Gehäuse (100) auf einem Substrat (116) gebildet ist, und wobei der Einfallfensterbereich (104) und der Ausfallfensterbereich (106) parallel zu dem Substrat (116) angeordnet sind.

9. Gehäuse (100) nach einem der Ansprüche 1 bis 8, wobei die Blende (108), der Einfallfensterbereich (104) und der Ausfallfensterbereich (106) zumindest einen Teil einer Deckenstruktur des Gehäuses (100) bilden.

10. Gehäuse (100) nach einem der Ansprüche 1 bis 9, wobei die Blende (102) bezogen auf den Einfallfensterbereich (104) oder Ausfallfensterbereich (106) schräg unter einem Winkel angeordnet ist.

11. Gehäuse (100) nach einem der Ansprüche 1 bis 10, wobei das Gehäuse (100) ausgebildet ist, um den Mikroscannerspiegel (102) Vakuum zu verkapseln.

12. Projektionssystem (200), mit folgenden Merkmalen:
einem Gehäuse (100) nach einem der Ansprüche 1 bis 11, wobei das Gehäuse (100) einen Mikroscannerspiegel (102) aufweist; und
einer Lichtquelle (202) zum emittieren eines Lichtstrahls (204);
wobei die Lichtquelle (202) und das Gehäuse (100) derart zueinander angeordnet sind, dass ein Nutzteil (206) des Lichtstrahls (204) durch den Einfallfensterbereich (104) auf den Mikroscannerspiegel (102) trifft und von dem Mikroscannerspiegel (102) in Richtung des Ausfallfensterbereichs (106) reflektiert wird, und dass ein parasitärer Teil (208) des Lichtstrahls (204), der von dem Einfallsfensterbereich (104) reflektiert wird, auf die Blende (108) trifft.

13. Projektionssystem (200) nach Anspruch 12, wobei die Lichtquelle (202) einen Laser (202) zum Emittieren eines Laserstrahls (204) aufweist.
